# EUROPEAN PATENT APPLICATION

(11) **EP 4 020 562 A1**
(43) Date of publication of application: **29.06.2022**
(21) Application number: 21209878.4
(22) Date of filing: 23.11.2021
(51) Int. Cl.: H01L 27/11514, H01L 27/24

(54) **3D-FERROELECTRIC RANDOM (3D-FRAM) WITH BURIED TRENCH CAPACITORS**

(30) Priority: 26.12.2020 US 202017134281
(71) Applicant: INTEL Corporation, Santa Clara, CA 95054 (US)
(72) Inventor: HARATIPOUR, Nazila, Portland, 97239 (US); CHANG, Sou-Chi, Portland, 97229 (US); SHIVARAMAN, Shriram, Hillsboro, 97006 (US); PECK, Jason, Hillsboro, 97124 (US); AVCI, Uygar, E., Portland, 97225 (US); KAVALIEROS, Jack T., Portland, 97229 (US)
(74) Representative: 2SPL Patentanwälte PartG mbB

(57) **Abstract**

A memory device comprises a series of alternating plate lines and an insulating material over a substrate. Two or more ferroelectric capacitors are through the series of alternating plate lines and an insulating material such that a first one of the ferroelectric capacitors is coupled to a first one of the plate lines and a second one of the ferroelectric capacitors is coupled to a second one of the plate lines. A plurality of substantially parallel bitlines is along a first direction over the two or more ferroelectric capacitors. A plurality of substantially parallel bitlines is along a first direction over the two or more ferroelectric capacitors. A plurality of substantially parallel wordlines is along a second direction orthogonal to the first direction over the two or more ferroelectric capacitors. An access transistor is located over and controls the two or more ferroelectric capacitors, the access transistor incorporating a first one of the bitlines and a first one of the wordlines. The bitline comprise a first source/drain of a source/drain pair, and a second source/drain is aligned, and in contact, with a top one of the two or more ferroelectric capacitors, and the first wordline forms a gate of the access transistor.

## Description

### TECHNICAL FIELD

Embodiments of the disclosure are in the field of integrated circuit structures and, in particular, a 3D-Ferroelectric Random (3D-FRAM) with buried trench capacitors.

### BACKGROUND

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for ever-more capacity, however, is not without issue. The necessity to optimize the performance of each device becomes increasingly significant.

Variability in conventional and state-of-the-art fabrication processes may limit the possibility to further extend them into the sub-10 nm range. Consequently, fabrication of the functional components needed for future technology nodes may require the introduction of new methodologies or the integration of new technologies in current fabrication processes or in place of current fabrication processes.

### BRIEF DESCRIPTION OF THE DRAWINGS

Figure 1 illustrates a cross-section of a 3D FRAM memory.
Figure 2 illustrates a cross-section of a 3D FRAM memory according to the disclosed embodiments.
Figures 3A-3C illustrate cross-sectional views showing a process for fabricating a 3D FRAM in further detail, where like reference numerals from Figure 2 have like reference numerals.
Figures 4A and 4B illustrate a wafer composed of semiconductor material and includes one or more dies having integrated circuit (IC) structures formed on a surface of the wafer.
Figure 5 illustrates a block diagram of an electronic system, in accordance with an embodiment of the present disclosure.
Figure 6 is a cross-sectional side view of an integrated circuit (IC) device assembly that may include one or more ferroelectric trench capacitors, in accordance with one or more of the embodiments disclosed herein.
Figure 7 illustrates a computing device in accordance with one implementation of the disclosure.

### DESCRIPTION OF THE EMBODIMENTS

A 3D-Ferroelectric Random (3D-FRAM) with buried trench capacitors is described. In the following description, numerous specific details are set forth, such as specific material and tooling regimes, in order to provide a thorough understanding of embodiments of the present disclosure. It will be apparent to one skilled in the art that embodiments of the present disclosure may be practiced without these specific details. In other instances, well-known features, such as single or dual damascene processing, are not described in detail in order to not unnecessarily obscure embodiments of the present disclosure. Furthermore, it is to be understood that the various embodiments shown in the Figures are illustrative representations and are not necessarily drawn to scale. In some cases, various operations will be described as multiple discrete operations, in turn, in a manner that is most helpful in understanding the present disclosure, however, the order of description should not be construed to imply that these operations are necessarily order dependent. In particular, these operations need not be performed in the order of presentation.

Certain terminology may also be used in the following description for the purpose of reference only, and thus are not intended to be limiting. For example, terms such as "upper", "lower", "above", "below," "bottom," and "top" refer to directions in the drawings to which reference is made. Terms such as "front", "back", "rear", and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

Embodiments described herein may be directed to front-end-of-line (FEOL) semiconductor processing and structures. FEOL is the first portion of integrated circuit (IC) fabrication where the individual devices (e.g., transistors, capacitors, resistors, etc.) are patterned in the semiconductor substrate or layer. FEOL generally covers everything up to (but not including) the deposition of metal interconnect layers. Following the last FEOL operation, the result is typically a wafer with isolated transistors (e.g., without any wires).

Embodiments described herein may be directed to back end of line (BEOL) semiconductor processing and structures. BEOL is the second portion of IC fabrication where the individual devices (e.g., transistors, capacitors, resistors, etc.) are interconnected with wiring on the wafer, e.g., the metallization layer or layers. BEOL includes contacts, insulating layers (dielectrics), metal levels, and bonding sites for chip-to-package connections. In the BEOL part of the fabrication stage contacts (pads), interconnect wires, vias and dielectric structures are formed. For modern IC processes, more than 10 metal layers may be added in the BEOL.

Embodiments described below may be applicable to FEOL processing and structures, BEOL processing and structures, or both FEOL and BEOL processing and structures. In particular, although an exemplary processing scheme may be illustrated using a FEOL processing scenario, such approaches may also be applicable to BEOL processing. Likewise, although an exemplary processing scheme may be illustrated using a BEOL processing scenario, such approaches may also be applicable to FEOL processing.

One or more embodiments may be implemented to realize a 3D-Ferroelectric Random (3D-FRAM) with buried trench capacitors. To provide context, a FRAM is a random-access memory similar in construction to DRAM but uses a ferroelectric layer instead of a dielectric layer to achieve non-volatility. Conventionally, both FRAM and DRAM are one transistor (1T)/one capacitor (1C) cell arrays.

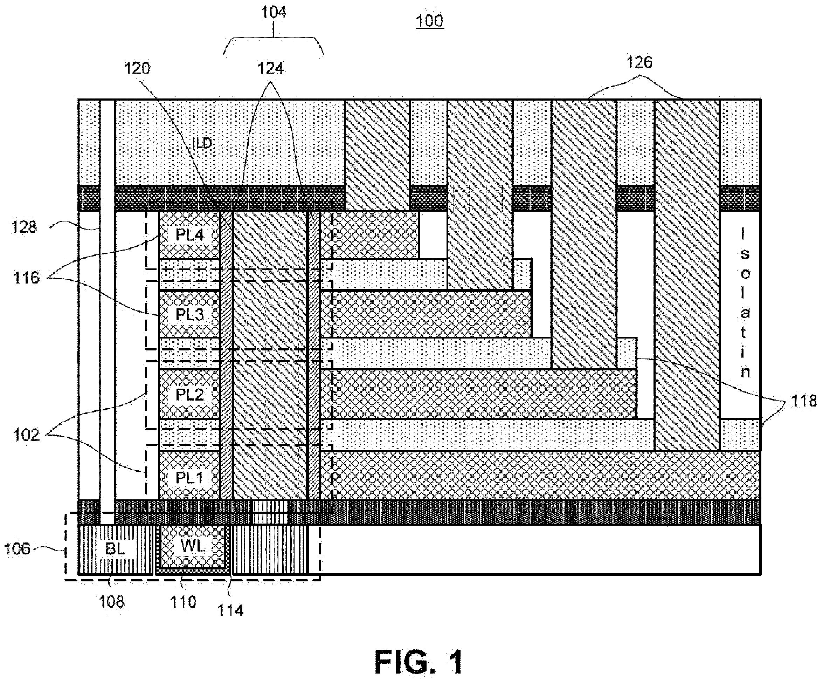

Figure 1 illustrates a cross-section of a 3D FRAM memory. The 3D FRAM memory 100 comprises a 3D array of ferroelectric capacitors 102 arranged in one or more vertical stacks or columns, each of the ferroelectric capacitors 102 in the stack is coupled to a single access transistor 106 at the base of the stack. The 3D FRAM memory 100 includes a base level having a plurality of substantially parallel bitlines 108 along a first direction. On a base +1 level, the 3D array comprises a plurality of substantially parallel wordlines 110 along a second direction, typically orthogonal to the first direction. The access transistor 106 is located at the intersection of a respective bitline 108 and a respective wordline 110 and is coupled to the respective bitline 108 and wordline 110.

Each stack 104 in the 3D array comprises a first ferroelectric capacitor 102 vertically aligned with and coupled to the access transistor 106 and at least a second ferroelectric capacitor 102 vertically aligned with the first of ferroelectric capacitor 102 and also coupled to the access transistor 106, wherein both the first ferroelectric capacitor 102 and the second ferroelectric capacitor 102 are controlled by the access transistor 106. In the example shown, the stack comprises four vertically stacked ferroelectric capacitors 102. In one embodiment, the access transistor 106 may be coupled to 2-8 ferroelectric capacitors 102.

Over the access transistor 106 is a stack of alternating plate lines 116 (e.g., PL1, PL2, PL3, PL4) and an insulating material 118 (e.g., an interlayer dielectric (ILD)) that may be substantially parallel to the bitlines 106. In one embodiment, the number of plate lines 116 equals the number of ferroelectric capacitors levels 102 in the stack 104. Accordingly, in the example shown, there are four ferroelectric capacitors 106, and four plate lines 116 separated by four layers of insulating material 118.

In one embodiment, a node 120 of each of the capacitors 106 is formed and located in a hole through the stack of alternating plate lines 116 and the insulating material 118 in alignment with the access transistor 106. The node 120 is one of the terminals of each of the ferroelectric capacitors 102 and is connected to, or comprises, a source/drain of the access transistor 106. Thus, the node 120 and the source/drain of the access transistor 106 are basically the same electrical point. The node 120 is surrounded by a ferroelectric (or antiferroelectric) material 124 that is conformal to sidewalls of the hole. The ferroelectric material 124 stores the memory state for a bit cell as a form of polarization, which can be switched by an electric field. The node 120 is further connected to one plate line 116 of each of the ferroelectric capacitors 102 in the stack 104. Each of the plate lines 116 acts as a first electrode and the node 120 acts as a second electrode for the corresponding ferroelectric capacitor 102 in the stack 104.

One advantage of the 3D FRAM memory 100 is that it enables cell scaling due to immunity to leakage and data is stored in the form of polarization in the capacitor. This type of storage allows the capacitors to be stacked to further scale the cell and achieve X Bit/Area monolithic integration where X is the number of stacked capacitors.

Although, the 3D FRAM memory 100 works for its intended purpose, one problem is that since the access transistor 106 is formed first in the FEOL, and then the ferroelectric capacitors 102 are formed, the thermal budget of the ferroelectric capacitors 102 may cause reliability concerns for the access transistor 106 during BEOL processing. In addition, forming the access transistor 106 at a base level in the FEOL means that any connections to the access transistor 106 must be made using a high aspect ratio etch to form a deep via 128 through ILD and isolation layers, as shown. Accordingly, there is a desire to make the fabrication process for the 3D FRAM memory 100 compatible with BEOL processing.

One or more embodiments described herein are directed to structures and architectures for fabricating a 3D-FRAM with buried trench capacitors and an access transistor formed on top. Rather than starting the fabrication process by forming the access transistor in a base level and then forming a ferroelectric capacitor stack over the access transistor, the disclosed embodiments make the fabrication process compatible with BEOL transistors by forming the ferroelectric capacitor stack first in the form of buried ferroelectric capacitors using any treatments that may require high thermal budget. The access transistor is then formed over the ferroelectric capacitor stack.

As a result of the fabrication process, a 3D FRAM memory device is formed having a series of alternating plate lines and an insulating material the access transistor. Two or more ferroelectric capacitors are over the access transistor and through the series of alternating plate lines and an insulating material such that a first one of the ferroelectric capacitors is coupled to a first one of the plate lines and a second one of the ferroelectric capacitors is coupled to a second one of the plate lines. A plurality of substantially parallel bitlines is along a first direction over the two or more ferroelectric capacitors. A plurality of substantially parallel wordlines is along a second direction orthogonal to the first direction over the two or more ferroelectric capacitors. An access transistor is located over and controls the two or more ferroelectric capacitors, the access transistor incorporating a first one of the bitlines and a first one of the wordlines. The bitline comprise a first source/drain of a source/drain pair, and a second source/drain is aligned, and in contact, with a top one of the two or more ferroelectric capacitors, and the first wordline forms a gate of the access transistor.

A 3D-FRAM fabricated by forming the buried ferroelectric capacitors first can avoid any potential thermal budget issues as any high thermal processing of the ferroelectric capacitors will not impact the access transistor. Forming the access transistor on top of the ferroelectric capacitor stack also avoids the need for any high aspect ratio etch to make connections to the access transistors. Embodiments may include or pertain to one or more of memory, ferroelectric memory, 3D ferroelectric memory and system-on-chip (SoC) technologies.

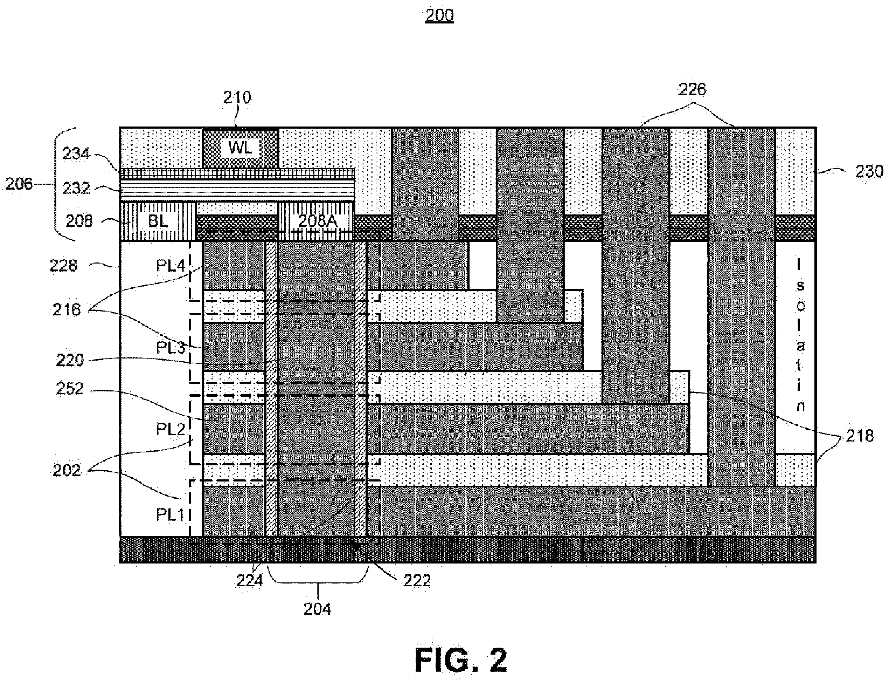

Figure 2 illustrates a cross-section of a 3D FRAM memory according to the disclosed embodiments. The 3D FRAM memory 200 is similar to the 3D FRAM memory 100 but locates an access transistor 206 on top of each stack 204 of ferroelectric capacitors 202. The 3D FRAM memory 200 includes an isolation region 228 over a substrate having a series of alternating plate lines 216 (e.g., PL1, PL2, PL3, PL4) and an insulating material 218 (e.g., an interlayer dielectric (ILD)) formed therein. The alternating plate lines 216 and an insulating material 218 may be substantially parallel to the bitlines 208 in one embodiment.

The 3D FRAM memory 200 further comprises a 3D array of two or more stacks 204 of ferroelectric capacitors 202 that are formed through the series of alternating plate lines 216 and the insulating material 218, such that a first one of the ferroelectric capacitors 202 is coupled to a first one of the plate lines 216 and a second one of the ferroelectric capacitors 202 is coupled to a second one of the plate lines 216. The two or more ferroelectric capacitors 202 are each coupled to and controlled by an access transistor 206 over the ferroelectric capacitors 202. A plurality of vias 226 is formed through an interlayer dielectric (ILD) 230 and the isolation region 228 so that each via 226 lands on a respective one of the plate lines 216. In one embodiment, the plurality of vias 226 may comprise the same metal material 252 as the plate lines 216. The ferroelectric capacitors 202 are arranged in a vertical stack 204 or column, where the stack 204 of ferroelectric capacitors 202 is coupled to the access transistor 206 at the top of the stack 204.

Each stack 204 in the 3D array comprises a first ferroelectric capacitor 202 vertically aligned with and coupled to the access transistor 206 and at least a second ferroelectric capacitor 202 vertically aligned with the first of ferroelectric capacitor 202 and also coupled to the access transistor 206, wherein both the first ferroelectric capacitor 202 and the second ferroelectric capacitor 202 are controlled by the access transistor 206. In the example shown, each stack 204 in the 3D array comprises four vertically stacked ferroelectric capacitors 202. In one embodiment, each access transistor 206 may be coupled to 2-8 ferroelectric capacitors 202.

In one embodiment, the number of plate lines 216 equals the number of ferroelectric capacitors 202 in the stack 204. Accordingly, in the example shown, there are four ferroelectric capacitors 206, and four plate lines 216 separated by four layers of insulating material 218. In one embodiment, a node 220 of each of the capacitors 206 is formed and located in a hole 222 through the stack of alternating plate lines 216 and the insulating material 218 in alignment with the corresponding channel region and the access transistor 206.

The 3D FRAM memory 200 further includes a plurality of substantially parallel (e.g., within +-5 degrees) bitlines 208 along a first direction, and a plurality of substantially parallel wordlines 210 along a second direction orthogonal to the first direction formed in an interlayer dielectric (ILD) 230 over the ferroelectric capacitor stack 204. In one embodiment, the bitlines 208 may run in a direction parallel to the plate lines 216 and the wordlines 210 may run in a direction in and out of the page in this view. In another embodiment, the wordlines 210 may run parallel to the plate lines 216 and the bitlines 208 may run in and out of the page.

Over the stacks of ferroelectric capacitors 202 is a plurality of access transistors 206, where each of the access transistors 206 is located over, and controls, one ferroelectric capacitor stack 204. Each of the access transistors 206 incorporates a respective bitline 208 and a respective wordline 210. In one embodiment, the bitline 208 may form one source/drain of a source/drain pair, and another source/drain 208A is aligned, and in contact, with a top one of the ferroelectric capacitors in the stack. A channel region 232 is over the source/drain pair, and a dielectric material 234 is over the channel region 232. The wordline 210 is over the dielectric material 234 and forms a gate of the access transistor 206.

The access transistor 206 may comprise any type of transistor, such as a planar transistor, a thin film transistor, a fin field effect transistor (FinFET), a vertical transistor, a 2D channel transistor, a polysilicon transistor or any layered transfer transistor, for example. In the embodiment of Figure 2, the access transistor 206 is shown as a thin film transistor.

The node 220 is one of the terminals of each of the ferroelectric capacitors 202 and is connected to, or comprises, a drain 208A of the access transistor 206. Thus, at least one source/drain of the access transistor 206 is in alignment with, and over the node 220, and the node 220 and the source/drain of the access transistor 206 are basically the same electrical point. The node 220 is surrounded by a ferroelectric (or antiferroelectric) material 224 that is conformal to sidewalls of the hole 222. The ferroelectric material 224 stores the memory state for a bit cell as a form of polarization, which can be switched by an electric field. The node 220 is further connected to one plate line 216 of each of the ferroelectric capacitors 202 in the stack 204. Each of the plate lines 216 acts as a first electrode and the node 220 acts as a second electrode for the corresponding ferroelectric capacitor 202 in the stack 204.

As described previously, the number of plate lines 216 may range from 2-8 using existing ferroelectric materials in the hole 222. The hole 222 may be approximately 30-200 nm in diameter/width, and in some embodiments up to 150 nm. The plate lines 216 may be up to approximately 100-300 nm in thickness, while the insulating material 218 may be up to approximately 50 nm in thickness. In one embodiment, the nodes 220 in each stack 204 may be up to approximately a maximum 2.4 microns in height (300 nm times × 8 plate lines). The node 220 and the channel region are aligned and have the same width, which provides the best area for a memory cell.

In some embodiments, the node 220 may comprise conductive material(s), e.g., metals, such as titanium, titanium nitride, or SrRuO₃ (SRO), as examples.

In some embodiments, one or more of the bitlines 208, the wordlines 210, the plate lines 216 and the via 226 may comprise conductive material(s), e.g., metals, such as titanium, titanium nitride, tantalum nitride, platinum, copper, tungsten, tungsten nitride, and/or ruthenium, among other conductive materials and/or combinations thereof.

In some embodiments, the ferroelectric/antiferroelectric material 224 comprising the ferroelectric capacitor may include, for example, materials exhibiting ferroelectric behavior at thin dimensions, such as hafnium zirconium oxide (HfZrO, also referred to as HZO, which includes hafnium, zirconium, and oxygen), zirconium oxide ZrO, Lanthanum-doped hafnium oxide La-HfO, Lanthanum-doped hafnium zirconium oxide La-HZO, silicon-doped (Si-doped) hafnium oxide (which is a material that includes hafnium, oxygen, and silicon), germanium-doped (Ge-doped) hafnium oxide (which is a material that includes hafnium, oxygen, and germanium), aluminum-doped (Al-doped) hafnium oxide (which is a material that includes hafnium, oxygen, and aluminum), yttrium-doped (Y- doped) hafnium oxide (which is a material that includes hafnium, oxygen, and yttrium), lead zirconate titanate (which is a material that includes lead, zirconium, and titanium), barium zirconate titanate (which is a material that includes barium, zirconium and titanium), and combinations thereof. Some embodiments include hafnium, zirconium, barium, titanium, and/or lead, and combinations thereof. In one embodiment, the ferroelectric material 224 may range from approximately 2 to 50 nm in thickness.

In one embodiment, insulating material 218 comprises interlayer dielectric (ILD) layers. In one embodiment, the insulating material 218 is an oxide layer, e.g., a silicon oxide layer. In one embodiment, insulating material 218 is a low-k dielectric, e.g., silicon dioxide, silicon oxide, carbon doped oxide ("CDO"), or any combination thereof. In one embodiment, the insulating material 218 can include a nitride, oxide, a ,polymer, phosphosilicate glass "fluorosilicate ( "SiOF" ) glass, organosilicate glass ( "SiOCH or any combination thereof. In another embodiment, the insulating materials 218 can include a nitride layer, e.g., silicon nitride layer. In alternative embodiments, the insulating materials 218 can include an aluminum oxide, silicon oxide nitride, other oxide/nitride layer, any combination thereof, or other electrically insulating layer determined by an electronic device design.

Each ferroelectric capacitor 202 and plate line 216 combination forms one of the bit cells that are vertically stacked over the access transistor 206. The dimensional requirements of the bit cells are determined primarily by the ferroelectric capacitor 202 or the wordline pitch and bitline pitch. The disclosed embodiment provide a 3D FRAM memory 200 having vertical geometry that provides benefits of 5-10× area/bit and cost/bit scaling. In one embodiment, the 3D FRAM memory 200 may have a bit cell area of 4*F*²/*n*, where *n* ≈ 8.

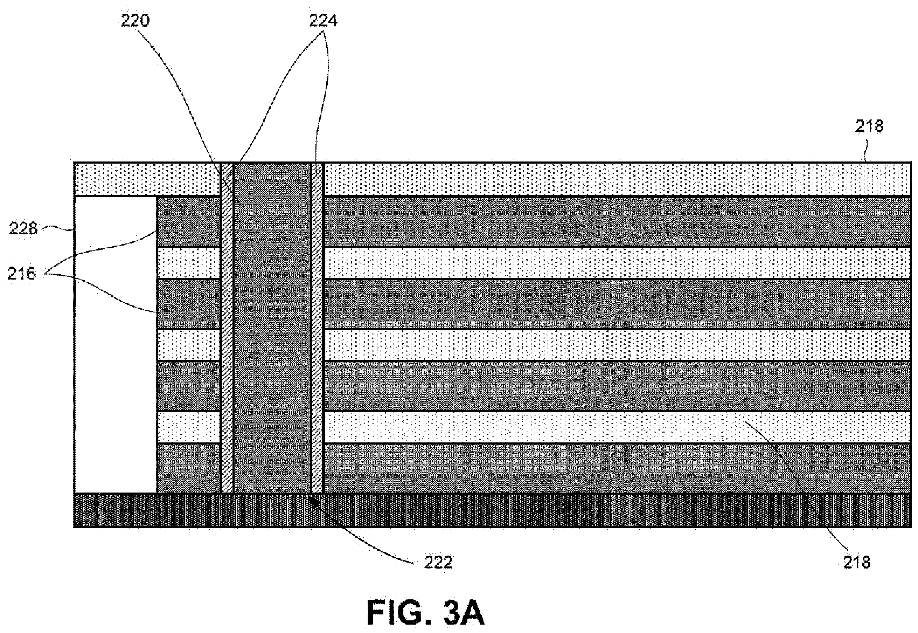

The fabrication process will now be described. Figures 3A-3C illustrate cross-sectional views showing a process for fabricating a 3D FRAM in further detail, where like reference numerals from Figure 2 have like reference numerals.

Figure 3A shows the process after a stack of alternating plate lines 216 and an insulating material 218 are blanket deposited over a substrate and in an isolation region 228. In one embodiment, the plate lines 216 comprise a metal material such as titanium, titanium nitride, tantalum nitride, platinum, copper, tungsten, tungsten nitride, ruthenium, or any combination thereof. In one embodiment, the insulating material 218 may comprise an oxide layer, e.g., a silicon oxide layer. In another embodiment, insulating material 218 is a low-k dielectric, e.g., silicon dioxide, carbon doped oxide ("CDO"), or any combination thereof.

Figure 3A further shows that after the deposition, a node 220 is formed for at least two ferroelectric capacitors, wherein the node is formed through the stack of alternating plate lines 216 and the insulating material 218. In further detail, a lithographic process is performed to etch holes 222 through the stack of alternating plate lines 216 and the insulating material 218. A ferroelectric (or antiferroelectric) material 224 is deposited conformal to sidewalls of the holes 222 and spacerized. The remainder of the hole 222 is filled with a metal and planarized to form the node 220. The metal may comprise metals, such as titanium, titanium nitride, tantalum nitride, platinum, copper, tungsten, tungsten nitride, and/or ruthenium, among other conductive materials and/or combinations thereof

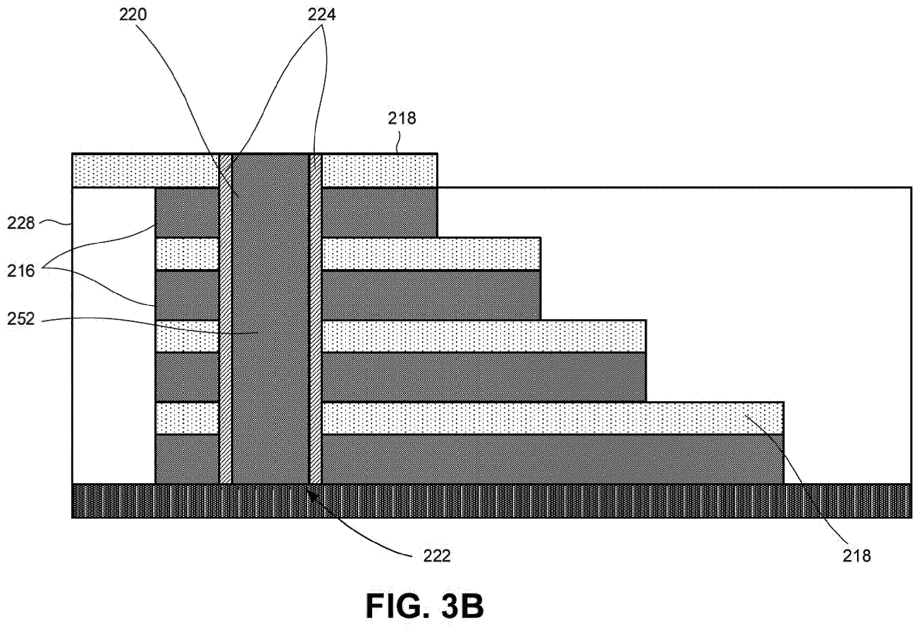

Figure 3B shows the process after a staircase etch is performed on an edge of the stack of alternating plate lines 216 and the insulating material 218. The staircase etch begins by depositing a thick hardmask on top of the stack, and a first etch is performed from the top of the stack of the metal/insulating material layers down to a top of the bottom insulating material 218 to form the first stair step. An isotropic etch is performed on the hardmask so that the hardmask shrinks on four sides, where one of the sides stops vertically over the position of the next stair step. A second etch is performed on the stack of the metal/insulating material layers down to the top of the second to bottom insulating material 218 to form a second stair step. Another isotropic etch is performed on the hardmask and the process repeats until the top metal/insulating material layer is etched.

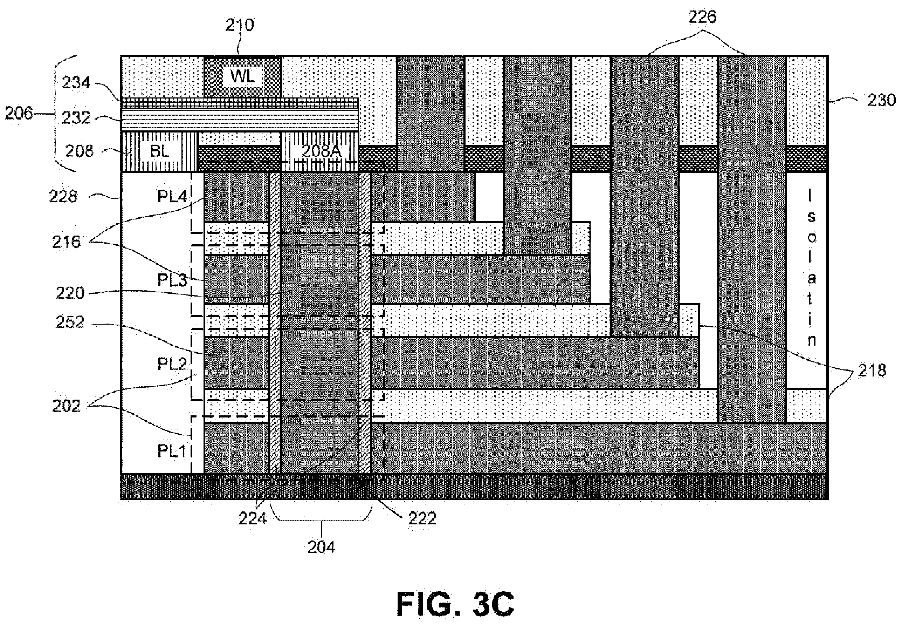

Figure 3C shows the process after the staircase etch, in which another ILD 230 is formed over isolation region 228. A lithographic process is performed on the ILD 230 to define contact and via locations. An etch is performed through the ILD 230 over the contact and via locations that stops on the plate lines 216 to form vias 226 through the ILD 230 and isolation region 228 that land on each of the plate lines 216 to form separate capacitors 202 that have a common node 220 at the center.

An array of FEOL access transistors 206 is then formed over the array of ferroelectric capacitors 202. This may be done by lithography to form pattern a plurality of substantially parallel bitlines 208 along a first direction within the ILD 230 and forming a plurality of substantially parallel wordlines 210 along a second direction orthogonal to the direction of the bitlines 208. Each access transistor 206 may be formed at the intersections of the bitlines 208 and wordlines 210, where a source/drain of the access transistor 206 is aligned, and in contact, with a top one of the two or more ferroelectric capacitors 202, and the wordline 210 forms a gate of the access transistor 206.

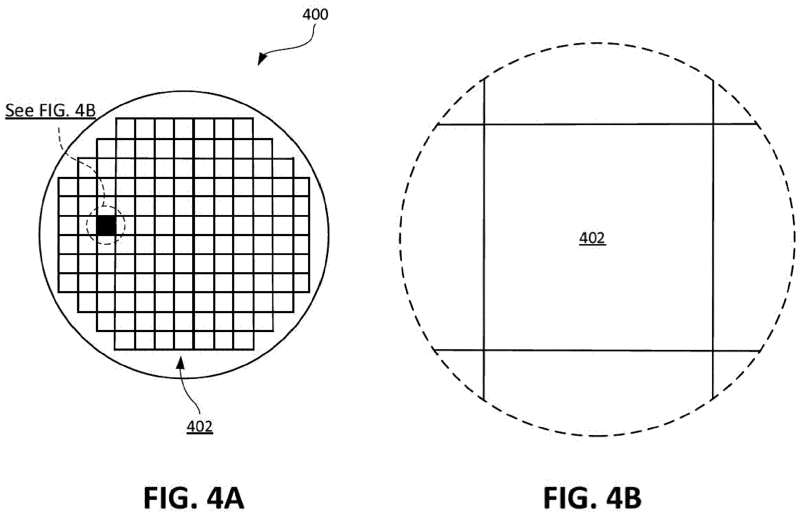

The integrated circuit structures described herein may be included in an electronic device. As an example of one such apparatus, Figures 4A and 4B are top views of a wafer and dies that include one or more ferroelectric trench capacitors, in accordance with one or more of the embodiments disclosed herein.

Referring to Figures 4A and 4B, a wafer 400 may be composed of semiconductor material and may include one or more dies 402 having integrated circuit (IC) structures formed on a surface of the wafer 400. Each of the dies 402 may be a repeating unit of a semiconductor product that includes any suitable IC (e.g., ICs including one or more ferroelectric trench capacitors, such as described above. After the fabrication of the semiconductor product is complete, the wafer 400 may undergo a singulation process in which each of the dies 402 is separated from one another to provide discrete "chips" of the semiconductor product. In particular, structures that include embedded non-volatile memory structures having an independently scaled selector as disclosed herein may take the form of the wafer 400 (e.g., not singulated) or the form of the die 402 (e.g., singulated). The die 402 may include one or more embedded non-volatile memory structures based independently scaled selectors and/or supporting circuitry to route electrical signals, as well as any other IC components. In some embodiments, the wafer 400 or the die 402 may include an additional memory device (e.g., a static random access memory (SRAM) device), a logic device (e.g., an AND, OR, NAND, or NOR gate), or any other suitable circuit element. Multiple ones of these devices may be combined on a single die 402. For example, a memory array formed by multiple memory devices may be formed on a same die 402 as a processing device or other logic that is configured to store information in the memory devices or execute instructions stored in the memory array.

Embodiments disclosed herein may be used to manufacture a wide variety of different types of integrated circuits and/or microelectronic devices. Examples of such integrated circuits include, but are not limited to, processors, chipset components, graphics processors, digital signal processors, micro-controllers, and the like. In other embodiments, semiconductor memory may be manufactured. Moreover, the integrated circuits or other microelectronic devices may be used in a wide variety of electronic devices known in the arts. For example, in computer systems (e.g., desktop, laptop, server), cellular phones, personal electronics, etc. The integrated circuits may be coupled with a bus and other components in the systems. For example, a processor may be coupled by one or more buses to a memory, a chipset, etc. Each of the processor, the memory, and the chipset, may potentially be manufactured using the approaches disclosed herein.

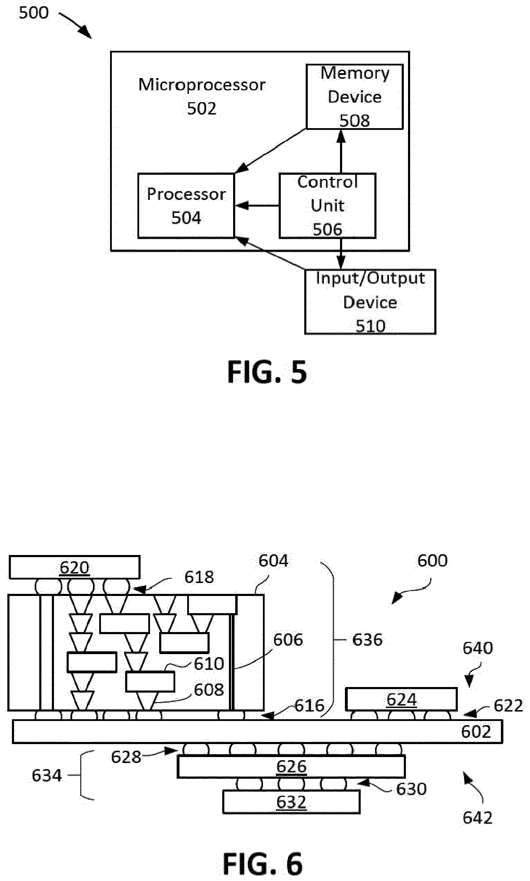

Figure 5 illustrates a block diagram of an electronic system 500, in accordance with an embodiment of the present disclosure. The electronic system 500 can correspond to, for example, a portable system, a computer system, a process control system, or any other system that utilizes a processor and an associated memory. The electronic system 500 may include a microprocessor 502 (having a processor 504 and control unit 506), a memory device 508, and an input/output device 510 (it is to be appreciated that the electronic system 500 may have a plurality of processors, control units, memory device units and/or input/output devices in various embodiments). In one embodiment, the electronic system 500 has a set of instructions that define operations which are to be performed on data by the processor 504, as well as, other transactions between the processor 504, the memory device 508, and the input/output device 510. The control unit 506 coordinates the operations of the processor 504, the memory device 508 and the input/output device 510 by cycling through a set of operations that cause instructions to be retrieved from the memory device 508 and executed. The memory device 508 can include a non-volatile memory cell as described in the present description. In an embodiment, the memory device 508 is embedded in the microprocessor 502, as depicted in Figure 5. In an embodiment, the processor 504, or another component of electronic system 500, includes one or more ferroelectric trench capacitors, such as those described herein.

Figure 6 is a cross-sectional side view of an integrated circuit (IC) device assembly that may include one or more ferroelectric trench capacitors, in accordance with one or more of the embodiments disclosed herein.

Referring to Figure 6, an IC device assembly 600 includes components having one or more integrated circuit structures described herein. The IC device assembly 600 includes a number of components disposed on a circuit board 602 (which may be, e.g., a motherboard). The IC device assembly 600 includes components disposed on a first face 640 of the circuit board 602 and an opposing second face 642 of the circuit board 602. Generally, components may be disposed on one or both faces 640 and 642. In particular, any suitable ones of the components of the IC device assembly 600 may include a number of ferroelectric trench capacitors, such as disclosed herein.

In some embodiments, the circuit board 602 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 602. In other embodiments, the circuit board 602 may be a non-PCB substrate.

The IC device assembly 600 illustrated in Figure 6 includes a package-on-interposer structure 636 coupled to the first face 640 of the circuit board 602 by coupling components 616. The coupling components 616 may electrically and mechanically couple the package-on-interposer structure 636 to the circuit board 602, and may include solder balls (as shown in Figure 6), male and female portions of a socket, an adhesive, an underfill material, and/or any other suitable electrical and/or mechanical coupling structure.

The package-on-interposer structure 636 may include an IC package 620 coupled to an interposer 604 by coupling components 618. The coupling components 618 may take any suitable form for the application, such as the forms discussed above with reference to the coupling components 616. Although a single IC package 620 is shown in Figure 6, multiple IC packages may be coupled to the interposer 604. It is to be appreciated that additional interposers may be coupled to the interposer 604. The interposer 604 may provide an intervening substrate used to bridge the circuit board 602 and the IC package 620. The IC package 620 may be or include, for example, a die (the die 402 of Figure 4B), or any other suitable component. Generally, the interposer 604 may spread a connection to a wider pitch or reroute a connection to a different connection. For example, the interposer 604 may couple the IC package 620 (e.g., a die) to a ball grid array (BGA) of the coupling components 616 for coupling to the circuit board 602. In the embodiment illustrated in Figure 6, the IC package 620 and the circuit board 602 are attached to opposing sides of the interposer 604. In other embodiments, the IC package 620 and the circuit board 602 may be attached to a same side of the interposer 604. In some embodiments, three or more components may be interconnected by way of the interposer 604.

The interposer 604 may be formed of an epoxy resin, a fiberglass-reinforced epoxy resin, a ceramic material, or a polymer material such as polyimide. In some implementations, the interposer 604 may be formed of alternate rigid or flexible materials that may include the same materials described above for use in a semiconductor substrate, such as silicon, germanium, and other group III-V and group IV materials. The interposer 604 may include metal interconnects 610 and vias 608, including but not limited to through-silicon vias (TSVs) 606. The interposer 604 may further include embedded devices, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio-frequency (RF) devices, power amplifiers, power management devices, antennas, arrays, sensors, and microelectromechanical systems (MEMS) devices may also be formed on the interposer 604. The package-on-interposer structure 636 may take the form of any of the package-on-interposer structures known in the art.

The IC device assembly 600 may include an IC package 624 coupled to the first face 640 of the circuit board 602 by coupling components 622. The coupling components 622 may take the form of any of the embodiments discussed above with reference to the coupling components 616, and the IC package 624 may take the form of any of the embodiments discussed above with reference to the IC package 620.

The IC device assembly 600 illustrated in Figure 6 includes a package-on-package structure 634 coupled to the second face 642 of the circuit board 602 by coupling components 628. The package-on-package structure 634 may include an IC package 626 and an IC package 632 coupled together by coupling components 630 such that the IC package 626 is disposed between the circuit board 602 and the IC package 632. The coupling components 628 and 630 may take the form of any of the embodiments of the coupling components 616 discussed above, and the IC packages 626 and 632 may take the form of any of the embodiments of the IC package 620 discussed above. The package-on-package structure 634 may be configured in accordance with any of the package-on-package structures known in the art.

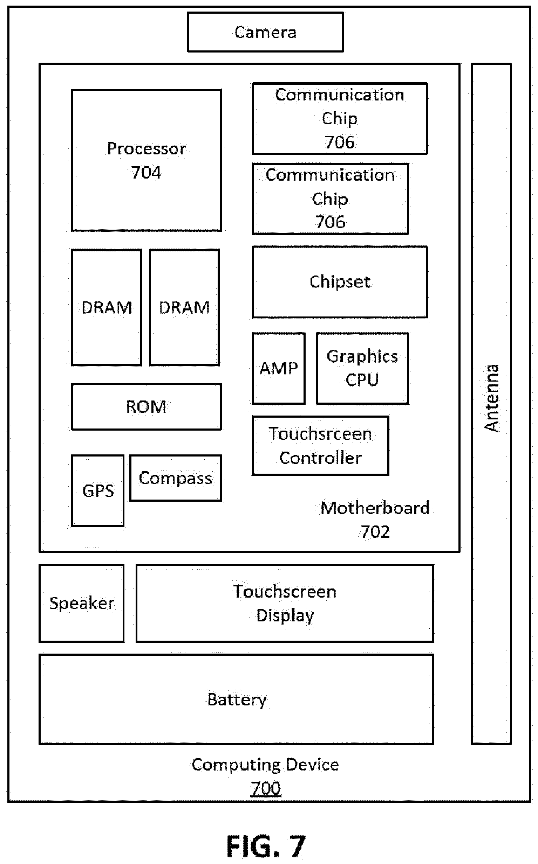

Figure 7 illustrates a computing device 700 in accordance with one implementation of the disclosure. The computing device 700 houses a board 702. The board 702 may include a number of components, including but not limited to a processor 704 and at least one communication chip 706. The processor 704 is physically and electrically coupled to the board 702. In some implementations the at least one communication chip 706 is also physically and electrically coupled to the board 702. In further implementations, the communication chip 706 is part of the processor 704.

Depending on its applications, computing device 700 may include other components that may or may not be physically and electrically coupled to the board 702. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 706 enables wireless communications for the transfer of data to and from the computing device 700. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 706 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 700 may include a plurality of communication chips 706. For instance, a first communication chip 706 may be dedicated to shorter range wireless communications such as Wi-Fi and Bluetooth and a second communication chip 706 may be dedicated to longer range wireless communications such as GPS, EDGE, GPRS, CDMA, WiMAX, LTE, Ev-DO, and others.

The processor 704 of the computing device 700 includes an integrated circuit die packaged within the processor 704. In some implementations of the disclosure, the integrated circuit die of the processor includes one or more ferroelectric trench capacitors, in accordance with implementations of embodiments of the disclosure. The term "processor" may refer to any device or portion of a device that processes electronic data from registers and/or memory to transform that electronic data into other electronic data that may be stored in registers and/or memory.

The communication chip 706 also includes an integrated circuit die packaged within the communication chip 706. In accordance with another implementation of embodiments of the disclosure, the integrated circuit die of the communication chip includes one or more ferroelectric trench capacitors, in accordance with implementations of embodiments of the disclosure.

In further implementations, another component housed within the computing device 700 may contain an integrated circuit die that includes one or more ferroelectric trench capacitors, in accordance with implementations of embodiments of the disclosure.

In various implementations, the computing device 700 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 700 may be any other electronic device that processes data.

Thus, embodiments described herein include a 3D FRAM with buried trench capacitors. The above description of illustrated implementations of embodiments of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.

Example embodiment 1: A memory device comprises a series of alternating plate lines and an insulating material over a substrate. Two or more ferroelectric capacitors is through the series of alternating plate lines and an insulating material such that a first one of the ferroelectric capacitors is coupled to a first one of the plate lines and a second one of the ferroelectric capacitors is coupled to a second one of the plate lines. A plurality of substantially parallel bitlines is along a first direction over the two or more ferroelectric capacitors. A plurality of substantially parallel bitlines is along a first direction over the two or more ferroelectric capacitors. A plurality of substantially parallel wordlines is along a second direction orthogonal to the first direction over the two or more ferroelectric capacitors. An access transistor is located over and controls the two or more ferroelectric capacitors, the access transistor incorporating a first one of the bitlines and a first one of the wordlines, wherein the bitline comprise a first source/drain of a source/drain pair, and a second source/drain is aligned, and in contact, with a top one of the two or more ferroelectric capacitors, and the first wordline forms a gate of the access transistor.

Example embodiment 2: The memory device of embodiment 1, wherein the first ferroelectric capacitor and the second ferroelectric capacitor further include: a node located in a hole through a stack of alternating plate lines and an insulating material, wherein the access transistor is in alignment with and over the node.

Example embodiment 3: The memory device of embodiment 2, wherein a number of the plate lines equals the number of ferroelectric capacitors levels in the stack.

Example embodiment 4: The memory device of embodiment 1, 2 or 3, wherein the number of the ferroelectric capacitors in the stack ranges from 2 to 8.

Example embodiment 5: The memory device of embodiment 1, 2, 3, or 4, wherein the bitline is a source of the access transistor, and the node is a drain of the access transistor.

Example embodiment 6: The memory device of embodiment 1, 2, 3, 4, or 5, wherein each of the plate lines act as a first electrode, and the node acts as a second electrode for the first ferroelectric capacitor and the second ferroelectric capacitor.

Example embodiment 7: The memory device of embodiment 1, 2, 3, 4, 5, or 6, further comprising: a ferroelectric material conformal to the sidewalls of the hole and surrounding the node.

Example embodiment 8: The memory device of embodiment 7 wherein the ferroelectric material comprises any combination of one or more of: hafnium, zirconium, and oxygen; hafnium, oxygen, and silicon; hafnium, oxygen, and germanium; hafnium, oxygen, and aluminum; hafnium, oxygen, lanthanum and yttrium; lead, zirconium, and titanium; barium, zirconium and titanium; hafnium, zirconium, barium, and titanium; and hafnium, zirconium, barium, and lead.

Example embodiment 9: The memory device of embodiment 1, 2, 3, 4, 5, 6, 7 or 8, wherein the hole is approximately 30-200 nm in diameter.

Example embodiment 10: The memory device of embodiment 1, 2, 3, 4, 5, 6, 7, 8, or 9, wherein the hole is approximately 150 nm in diameter.

Example embodiment 11: The memory device of embodiment 1, 2, 3, 4, 5, 6, 7, 8, 9, or 10, wherein the plate lines are up to approximately 300 nm in thickness, and the insulating material are up to approximately 50 nm in thickness.

Example embodiment 12: The memory device of embodiment 1, 2, 3, 4, 5, 6, 7, 8, 9, 10 or 11, wherein the ferroelectric material ranges from approximately 2 to 50 nm in thickness.

Example embodiment 13: A memory device comprises a 3D array of ferroelectric capacitors is arranged in a plurality of vertical stacks. A single access transistor is over each of the vertical stacks and is coupled to the ferroelectric capacitors in the respective vertical stacks, the access transistor comprising a channel, a source and a drain. A plurality of bitlines is along a first direction, wherein a first one of the bitlines comprise a source/drain. A plurality of wordlines is over the bitlines and the channel along a second direction, wherein a first one of the wordlines comprises a gate of the access transistor.

Example embodiment 14: The memory device of embodiment 13, wherein the two or more ferroelectric capacitors are formed in a hole through the series of alternating plate lines and an insulating material, and wherein the hole is lined with a ferroelectric or antiferroelectric material and filled with a conductive material to form a node.

Example embodiment 15: The memory device of embodiment 14, wherein the hole is approximately 30-200 nm in diameter.

Example embodiment 16: The memory device of embodiment 14, wherein the hole is approximately 150 nm in diameter.

Example embodiment 17: The memory device of embodiment 13, 14, 15 or 16, wherein the access transistor comprises one of a planar transistor, a thin film transistor, a fin field effect transistor (FinFET), a 2D channel transistor, a polysilicon transistor or any layered transfer transistor.

Example embodiment 18: The memory device of embodiment 13, 14, 15, 16 or 17, further comprising a channel region over a source/drain pair, and a dielectric material over the channel region.

Example embodiment 19: The memory device of embodiment 13, 14, 15, 16, 17 or 18, wherein the bitline is a drain of the access transistor, and the node is a source of the access transistor.

Example embodiment 20: The memory device of embodiment 13, 14, 15, 16, 17, 18, or 19, wherein the plate lines are up to approximately 300 nm in thickness, and the insulating material are up to approximately 50 nm in thickness.

Example embodiment 21: The memory device of embodiment 13, 14, 15, 16, 17, 18, 19 or 20 , wherein the ferroelectric material comprises any combination of one or more of: hafnium, zirconium, and oxygen; hafnium, oxygen, and silicon; hafnium, oxygen, and germanium; hafnium, oxygen, and aluminum; hafnium, oxygen, and yttrium; hafnium, oxygen, and lanthanum; lead, zirconium, and titanium; barium, zirconium and titanium; hafnium, zirconium, barium, and titanium; and hafnium, zirconium, barium, and lead.

Example embodiment 22: A method of fabricating a memory device comprises blanket depositing a stack of alternating plate lines and an insulating material over a substrate and in an isolation region. A node is formed for at least two ferroelectric capacitors, the node formed through the stack of alternating plate lines and the insulating material. A staircase etch is performed on the stack of alternating plate lines in the insulator material. An interlayer dielectric (ILD) is formed over the isolation region and contact and via locations are defined. An etch of the ILD is performed over the contact and via locations that stops on plate lines to form vias through the ILD and the isolation region that land on each of the plate lines to form separate capacitors that have a common node at the center. An access transistor is over the node of the least two ferroelectric capacitors.

Example embodiment 23: The embodiment of embodiment 22, wherein forming the node further comprises etching a hole through the stack of alternating dummy nitride material and the insulating material down to a source or drain of the access transistor; and depositing a ferroelectric or antiferroelectric material conformal to sidewalls of the holes.

Example embodiment 24: The method of embodiment 23 comprising depositing the ferroelectric material as any combination of one or more of: hafnium, zirconium, and oxygen; hafnium, oxygen, and silicon; hafnium, oxygen, and germanium; hafnium, oxygen, and aluminum; hafnium, oxygen, and yttrium; hafnium, oxygen, and lanthanum; lead, zirconium, and titanium; barium, zirconium and titanium; hafnium, zirconium, barium, and titanium; and hafnium, zirconium, barium, and lead.

Example embodiment 25: the method of embodiment 22, 23 or 24, wherein forming the access transistor further comprises patterning a plurality of substantially parallel bitlines along a first direction within an insulating material over a substrate and forming a plurality of substantially parallel wordlines along a second direction orthogonal to the direction of the bitlines, and forming the access transistor at the intersection of the one of the bitlines and one of the wordlines, wherein a source/drain of the access transistor is aligned, and in contact, with a top one of the two or more ferroelectric capacitors, and the wordline forms a gate of the access transistor.

## Claims

1. A memory device, comprising:
a series of alternating plate lines and an insulating material over a substrate;
two or more ferroelectric capacitors are through the series of alternating plate lines and an insulating material such that a first one of the ferroelectric capacitors is coupled to a first one of the plate lines and a second one of the ferroelectric capacitors is coupled to a second one of the plate lines;
a plurality of substantially parallel bitlines along a first direction over the two or more ferroelectric capacitors;
a plurality of substantially parallel wordlines along a second direction orthogonal to the first direction over the two or more ferroelectric capacitors; and
an access transistor is located over and controls the two or more ferroelectric capacitors, the access transistor incorporating a first one of the bitlines and a first one of the wordlines, wherein the bitline comprise a first source/drain of a source/drain pair, and a second source/drain is aligned, and in contact, with a top one of the two or more ferroelectric capacitors, and the first wordline forms a gate of the access transistor.

2. The memory device of claim 1, wherein the first ferroelectric capacitor and the second ferroelectric capacitor further include: a node located in a hole through a stack of alternating plate lines and an insulating material, wherein the access transistor is in alignment with and over the node.

3. The memory device of claim 2, wherein a number of the plate lines equals the number of ferroelectric capacitors levels in the stack.

4. The memory device of claim 1, 2 or 3, wherein the number of the ferroelectric capacitors in the stack ranges from 2 to 8.

5. The memory device of claim 1, 2, 3 or 4, wherein the bitline is a source of the access transistor, and the node is a drain of the access transistor.

6. The memory device of claim 1, 2, 3, 4 or 5, wherein each of the plate lines act as a first electrode and the node acts as a second electrode for the first ferroelectric capacitor and the second ferroelectric capacitor.

7. The memory device of claim 1, 2, 3, 4, 5 or 6, further comprising: a ferroelectric material conformal to the sidewalls of the hole and surrounding the node.

8. The memory device of claim 7, wherein the ferroelectric material comprises any combination of one or more of: hafnium, zirconium, and oxygen; hafnium, oxygen, and silicon; hafnium, oxygen, and germanium; hafnium, oxygen, and aluminum; hafnium, oxygen, and yttrium; hafnium, oxygen, and lanthanum; lead, zirconium, and titanium; barium, zirconium and titanium; hafnium, zirconium, barium, and titanium; and hafnium, zirconium, barium, and lead.

9. The memory device of claim 1, 2, 3, 4, 5, 6, 7 or 8, wherein the hole is approximately 30-200 nm in diameter.

10. The memory device of claim 1, 2, 3, 4, 5, 6, 7, 8 or 9, wherein the hole is approximately 150 nm in diameter.

11. The memory device of claim 1, 2, 3, 4, 5, 6, 7, 8, 9 or 10, wherein the plate lines are up to approximately 300 nm in thickness, and the insulating material is up to approximately 50 nm in thickness.

12. The memory device of claim 1, 2, 3, 4, 5, 6, 7, 8, 9, 10 or 11, wherein the ferroelectric material is approximately 2 to 50 nm in thickness.

13. A method of fabricating a memory device, the method comprising:
blanket depositing a stack of alternating plate lines and an insulating material over a substrate and in an isolation region;
forming a node for at least two ferroelectric capacitors, the node formed through the stack of alternating plate lines and the insulating material;
performing a staircase etch on the stack of alternating plate lines in the insulator material;
forming an interlayer dielectric (ILD) over the isolation region and defining contact and via locations;
performing an etch of the ILD over the contact and via locations that stops on plate lines to form vias through the ILD and the isolation region that land on each of the plate lines to form separate capacitors that have a common node at the center; and
forming an access transistor over the node of the least two ferroelectric capacitors.

14. The method of claim 13, wherein forming the node further comprises:
etching a hole through the stack of alternating dummy nitride material and the insulating material down to a source or drain of the access transistor; and
depositing a ferroelectric or antiferroelectric material conformal to sidewalls of the holes.

15. The method of claim 14, further comprising depositing the ferroelectric material as any combination of one or more of: hafnium, zirconium, and oxygen; hafnium, oxygen, and silicon; hafnium, oxygen, and germanium; hafnium, oxygen, and aluminum; hafnium, oxygen, and yttrium; hafnium, oxygen, and lanthanum; lead, zirconium, and titanium; barium, zirconium and titanium; hafnium, zirconium, barium, and titanium; and hafnium, zirconium, barium, and lead.
